# EUROPÄISCHE PATENTSCHRIFT

(11) **EP 2 744 997 B1**
(45) Veröffentlichungstag und Bekanntmachung des Hinweises auf die Patenterteilung: **20.01.2021**
(21) Anmeldenummer: 12748486.3
(22) Anmeldetag: 20.08.2012
(51) Int. Cl.: F02D 41/20, H01L 41/22, H01L 41/257, H01L 41/083, H02N 2/06

(54) **VERFAHREN UND VORRICHTUNG ZUR ANSTEUERUNG EINES PIEZOELEKTRISCHEN AKTORS**
METHOD AND DEVICE FOR DRIVEING A PIEZOELECTRIC ACTUATOR
PROCÉDÉ ET DISPOSITIF DE COMMANDE D'UN ACTIONNEUR PIÉZOÉLECTRIQUE

(30) Priorität: 18.08.2011 DE 102011081161
(43) Veröffentlichungstag der Anmeldung: 25.06.2014
(73) Patentinhaber: Vitesco Technologies GmbH, 30165 Hannover (DE)
(72) Erfinder: JUNG, Uwe, 93086 Wörth a. d. Donau (DE)
(86) Internationale Anmeldenummer: PCT/EP2012/066210
(87) Internationale Veröffentlichungsnummer: WO 2013/024179

(56) Entgegenhaltungen:
- EP-A1- 1 515 377
- DE-A1- 19 905 340
- DE-A1-102004 018 211
- DE-A1-102004 046 080
- DE-A1-102005 015 257

## Beschreibung

Die Erfindung betrifft ein Verfahren zum Ansteuern eines piezoelektrischen Aktors mit einem piezoelektrischen Stapel, der insbesondere als Stellglied eines Injektors betrieben wird. Ferner betrifft die Erfindung eine Anordnung zur Ansteuerung eines solchen piezoelektrischen Aktors.

Ein piezoelektrischer Stapel ist ein Bauteil, das durch Anlegen einer elektrischen Spannung eine mechanische Bewegung ausführt. Ein piezoelektrischer Stapel umfasst eine Mehrzahl von auf Anlegen eines elektrischen Feldes reagierenden Werkstoffschichten und einer Mehrzahl von Elektrodenschichten, wobei jede Werkstoffschicht zwischen zwei der Elektrodenschichten angeordnet ist. Die Werkstoffschichten sind üblicherweise aus Keramik gebildet.

Das Material der Werkstoffschichten ist ferroelektrisch und wird bei seiner Herstellung durch Erhitzen über die ferroelektrische Curie-Temperatur und nachfolgendes Abkühlen in einem elektrischen Feld polarisiert. Diesen Vorgang im Rahmen der Herstellung nennt man Polungsprozess. Dadurch werden die zuerst zufällig ausgerichteten Dipolmomente (Weiss-Bezirke) weitgehend parallel ausgerichtet.

Durch den Betrieb des Piezostapels im Regelbetrieb mit einer Feldstärke, die kleiner als die Feldstärke bei einem Polungsvorgang ist, kommt es im Laufe der Zeit zu einer Depolarisation (Rückorientierung) der Dipolmomente, welche auch als Domänen bezeichnet werden. Der gleiche Effekt tritt auf, wenn der Piezostapel wechselnden Temperaturen ausgesetzt wird, auch wenn kein elektrisches Feld anliegt. Dieser Effekt führt zu einer Längenänderung des Piezostapels.

Unter Regelbetrieb versteht man in diesem Zusammenhang den Betrieb des Piezostapels unter den Bedingungen seiner Zweckbestimmung. Die Zweckbestimmung des Piezostapels kann beispielsweise die Verwendung innerhalb eines Aktors eines (K*raftstoff-) Einspritzventils* - *oder auch:* (Kraftstoff-) Injektors) sein, beispielsweise innerhalb eines Kraftfahrzeugs. Unter Regelbetrieb versteht man in diesem Fall den normalen (Regel-) Betrieb eines Fahrzeugs.

Wenn der Piezostapel als Stellglied, z.B. als Betätigungselement in Einspritzventilen der verschiedensten Motortypen für Kraftfahrzeuge, benutzt wird, führt dies zu einer veränderten Nullpunktlage. Bei der Verwendung eines Piezostapels in einem Einspritzventil kann daher ein sog. Leerhub auftreten, der die Funktion bzw. Effizienz eines Motors beeinträchtigen kann.

Insbesondere beim Einsatz als Stellglied eines Einspritzventils (Injektors) führen die beschriebenen Effekte dazu, dass die dynamische Veränderung der Längenänderung des Piezostapels berücksichtigt werden muss, um eine Funktionssicherheit des Injektors zu gewährleisten. Um eine Nullpunktslage, die aus einer definierten Solllänge des Piezostapels resultiert, sicherstellen zu können, werden beispielsweise hydraulische Wegkompensatoren oder Schaltungen verwendet, welche einen verpolten Betrieb des Piezostapels erlauben. Eine weitere bekannte Variante detektiert die Abweichung einer Längenänderung und korrigiert eine von der Solllänge abweichende Länge des Piezostapels, indem eine Kompensation der Totzeit der Bewegung mittels geänderter Ansteuerparameter erfolgt.

DE 10 2005 015 257 A1 offenbart ein Ansteuerverfahren für einen piezoelektrischen Aktor, der in einem Arbeitsbetrieb mit einer Betätigungsspannung und in einem Wiederherstellungsbetrieb mit einer Regenerationsspannung beaufschlagt wird. Die Regenerationsspannung ist dabei entgegen der Betätigungsspannung im Arbeitsbetrieb gerichtet und erzeugt innerhalb eines Materials des Aktors eine elektrische Feldstärke, die größer ist als die Koerzitivfeldstärke des Materials des Aktors.

In EP 1 515 377 A1 ist ein Verfahren zum Betrieb eines Injektors mit einem piezoelektrischen Aktuator beschrieben, wobei bei vorbestimmten Bedingungen eine Regenerationsspannung auf den Aktor aufgebracht wird, die gleich oder größer ist zu der Koerzitivspannung des Aktors.

In DE 199 05 340 A1 ist ein Verfahren zum Einstellen eines gewünschten Leerhubs zwischen einem Piezoaktor und einem Betätigungselement beschrieben.

Es ist Aufgabe der vorliegenden Erfindung, eine Möglichkeit zur eine Ansteuerung eines piezoelektrischen Aktors anzugeben, bei denen eine Nullpunktslage des piezoelektrischen Aktors auf einfachere Weise gelöst werden kann.

Diese Aufgabe wird gelöst durch ein Verfahren gemäß den Merkmalen des Patentanspruches 1 sowie eine Anordnung zur Ansteuerung gemäß den Merkmalen des Patentanspruches 8. Vorteilhafte Ausgestaltungen ergeben sich aus den abhängigen Patentansprüchen.

Die Erfindung schafft ein Verfahren zum Ansteuern eines piezoelektrischen Aktors mit einem Piezostapel, der insbesondere als Stellglied eines Injektors betrieben wird, wobei es sich bei dem Piezostapel um einen im Rahmen seiner Herstellung durch einen Polungsprozess initial mit einer ersten Feldstärke gepolten piezostapel handelt, woraus eine erste initiale Länge des Piezostapels resultiert. Bei dem Verfahren wird der Piezostapel im Regelbetrieb , insbesondere im Regelbetrieb eines Kraftfahrzeuges mit einem solchen piezoelektrischen Aktor und Piezostapel, mit einer zweiten Feldstärke angesteuert, die kleiner als die erste Feldstärke ist, wobei in Abhängigkeit der zweiten Feldstärke eine Solllänge des Piezostapels definiert ist. Eine durch Depolarisation verursachte Abweichung von der Solllänge des Piezostapels im Regelbetrieb wird überwacht. Bei Erreichen eines vorgegebenen Schwellwerts der Längenänderung wird der Piezostapel mit einer dritten Feldstärke bis zum Erreichen seiner Solllänge betrieben.

Die Erfindung schafft weiter eine Anordnung zur Ansteuerung eines piezoelektrischen Aktors für einen Kraftstoffinjektor, der einendurch einen im Rahmen seiner Herstellung erfolgten Polungsprozess initial mit einer ersten Feldstärke gepolten Piezostapel aufweist, woraus eine erste Länge des Piezostapels resultiert. Die Anordnung zur Ansteuerung ist dazu ausgebildet, den Piezostapel im Betrieb mit einer zweiten Feldstärke anzusteuern, die kleiner als die erste Feldstärke ist, wobei in Abhängigkeit der zweiten Feldstärke eine Solllänge des Piezostapels definiert ist. Die Ansteuerung ist weiter dazu ausgebildet, eine durch Depolarisation verursachte Abweichung von der Solllänge des Piezostapels zu überwachen. Ferner ist die Anordnung zur Ansteuerung dazu ausgebildet, bei Erreichen eines vorgegebenen Schwellwerts der Längenänderung den Piezostapel mit einer dritten Feldstärke bis zum Erreichen seiner Solllänge zu betreiben.

Der Erfindung liegt die Erkenntnis zu Grunde, dass bei einem Betrieb des Piezoaktors mit einer höheren Feldstärke als der zur Polung verwendeten Feldstärke es zu einem "Nachpolungseffekt" kommt, der zu einer stärkeren Ausrichtung der Domänen führt. Dies sorgt für eine Verlängerung des depolarisierten Piezostapels, so dass dieser auf seine Solllänge zurückgeführt werden kann.

Das erfindungsgemäße Vorgehen ermöglicht eine aktive Nulllagenkorrektur des Piezostapels. Ein Vorteil des Vorgehens besteht darin, dass im Gegensatz zu aus dem Stand der Technik bekannten Lösungen kein hydraulischer Spielausgleich notwendig ist, um eine Wegkompensation zur Vermeidung eines Totweges sicherzustellen. Ebenso kann auf teure, aufwändige bipolare Schaltungen verzichtet werden, welche in bekannten Lösungen die Nullpunktslage gewährleisten. Im Gegensatz zu reinen Adaptionsverfahren, wie diese im Stand der Technik verwendet werden, schlägt das erfindungsgemäße Vorgehen eine tatsächliche, physikalische Korrektur der Nullpunktslage vor. Ein Vorteil besteht darin, dass das Design des Injektors, in dem der Piezostapel als Stellglied betrieben wird, keine Rücksicht auf Verschiebungen der Nullpunktslage nehmen muss.

Vorteilhafterweise kann die Verschiebung der Nullpunktslage im Regelbetrieb des Injektors korrigiert werden.

Insbesondere ist die dritte Feldstärke, welche zur aktiven Längenänderung und damit Nullpunktskorrektur verwendet wird, größer als die zweite Feldstärke. Weiter bevorzugt ist die dritte Feldstärke auch größer als die erste Feldstärke.

Gemäß einer weiteren zweckmäßigen Ausgestaltung wird der Piezostapel nach Erreichen des vorgegebenen Schwellwerts kontinuierlich mit der dritten Feldstärke betrieben, bis die tatsächlichen Längen des Piezostapels der Solllänge entspricht. In entsprechender Weise ist die erfindungsgemäße Ansteuerung in einer Weiterbildung dazu ausgebildet, den Piezostapel kontinuierlich mit der dritten Feldstärke zu betreiben, bis die tatsächliche Länge des Piezostapels der Solllänge entspricht. In einer Weiterbildung des erfindungsgemäßen Verfahrens wird der Piezostapel nach erneutem Erreichen seiner Solllänge mit der zweiten Feldstärke betrieben. In entsprechender Weise ist hierzu die erfindungsgemäße Ansteuerung in einer Weiterbildung ausgebildet.

Gemäß einer weiteren zweckmäßigen Ausgestaltung wird die Solllänge, welche eine Ausgangslage des Piezostapels ohne Ansteuerung vorgibt, durch ein Leerhub-Detektionsverfahren ermittelt.

In einer weiteren zweckmäßigen Ausgestaltung wird ebenfalls die Längenänderung durch ein Leerhub-Detektionsverfahren ermittelt. Die erfindungsgemäße Ansteuerung ist entsprechend ausgebildet, ein solches Leerhub-Detektionsverfahren durchzuführen. Ein solches kann z.B., wie in der WO 2006/029931 A1 beschrieben, durchgeführt werden.

Die Erfindung wird nachfolgend näher anhand eines Ausführungsbeispiels in der Zeichnung erläutert. Es zeigen:
- Fig. 1: eine Darstellung unterschiedlicher Längen eines piezoelektrischen Aktors mit einem Piezostapel in unterschiedlichen Zuständen, und
- Fig. 2: ein Diagramm, das die Längenänderung eines gepolten Piezostapels in Abhängigkeit unterschiedlicher, auf ihn einwirkender elektrischer Felder darstellt.

Die Ansteuerung eines piezoelektrischen Aktors mit einem Piezostapel geht davon aus, dass die Feldstärke VPol beim Polungsprozess der Keramikschichten des Piezostapels und die Feldstärke im Betrieb des Piezostapels VOp im Allgemeinen so gewählt sind, dass der normale Betrieb (oder auch: Regelbetrieb) des Piezostapels, z.B. als Stellglied eines Injektors eines Motors, zu einer Depolarisation seiner Domänen führt. Dies führt, wie auftretende Temperaturänderungen, zu einer sicheren Verkürzung des Piezostapels.

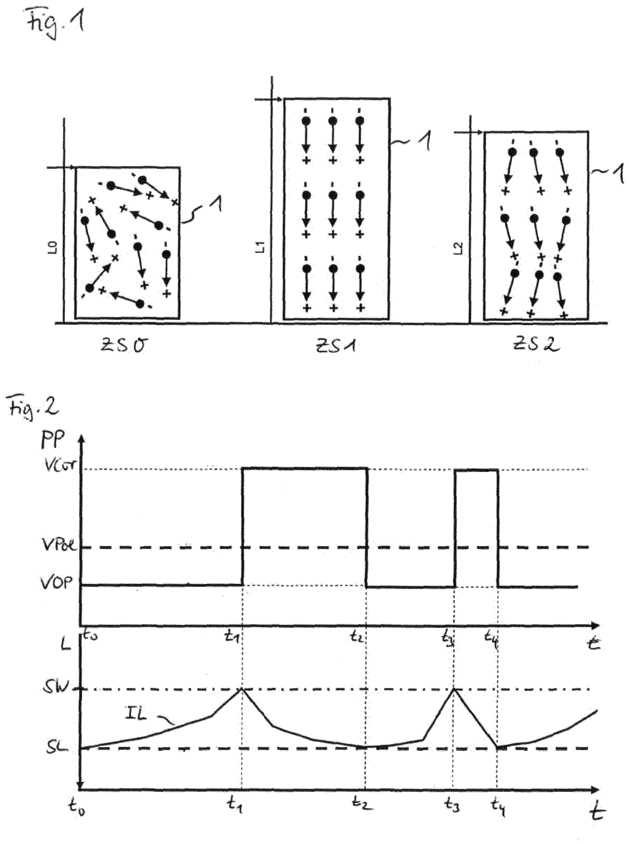

Fig. 1 zeigt die Längen L0, L1 und L2 eines Piezostapels 1 in unterschiedlichen Zuständen ZS0, ZS1 und ZS2. Der Piezostapel 1 weist im Zustand ZS0, in dem der Piezostapel 1 ungepolt ist, eine Länge L0 auf. Im Zustand ZS0 sind die Dipolmomente der Keramikschichten noch zufällig ausgerichtet. Die Dipolmomente werden auch als Weiss-Bezirke oder Domänen bezeichnet. Aufgrund der Durchführung des Polungsprozesses, in dem die Keramikschichten des Piezostapels 1 einem Feld mit einer ersten elektrischen Feldstärke VPol beaufschlagt wird, vergrößert sich die Länge auf L1. Dabei repräsentiert der Zustand ZS1, in dem der Piezostapel 1 die Länge L1 aufweist, einen Zustand, in dem der Piezostapel gepolt und noch nicht betrieben ist. Nach der Polung (Zustand ZS1) sind die Dipolmomente weitgehend parallel ausgerichtet.

Zustand ZS2 zeigt die Situation, in der der Piezostapel 1 gepolt ist und mit einer elektrischen Feldstärke VOp betrieben wird, welche kleiner als die Feldstärke VPol ist,wie dies im Regelbetrieb üblicherweise der Fall ist. Dies führt zu einer Depolarisation, d.h. Rückorientierung, der Dipolmomente bzw. Domänen. Hierdurch ergibt sich (über die Zeit) eine zunehmende Reduktion der Länge, welche in Fig. 1 bei ZS2 mit L2 gekennzeichnet ist.

Dieser Vorgang ist in den Diagrammen der Fig. 2 besser ersichtlich. Dargestellt sind über die Zeit t ein Polungsparameter PP, wie z.B. die an dem Piezostapel 1 angelegte Spannung bzw. die daraus resultierende Feldstärke, sowie die Länge L des Piezostapels. Im Länge-Zeit-Diagramm der Fig. 2 ist zu beachten, dass die Länge L nach unten größer und nach oben kleiner dargestellt ist.

Im oberen Diagramm ist somit der Verlauf der elektrischen Feldstärke über die Zeit dargestellt, mit der der Piezostapel beaufschlagt ist.

Die Beaufschlagung kann dabei insbesondere in der Form von einzelnen Beaufschlagungspulsen erfolgen, weshalb die Darstellung in diesem Fall als Darstellung der gewählten Amplituden der Ansteuerpulse während des dargestellten Zeitraums zu verstehen ist.

Zu einem Zeitpunkt t0 weist der Piezostapel eine Solllänge SL auf. Zwischen t0 und t1 wird der Piezostapel mit der Feldstärke VOp betrieben. Hierdurch ergibt sich die bereits beschriebene Längenänderung, d.h. Verkürzung, welche durch die Istlänge IL im unteren Diagramm erkennbar ist. Zum Zeitpunkt t1 erreicht die Istlänge IL einen vorgegebenen Schwellwert SW für die Längenänderung, so dass eine aktive Nullpunktkorrektur erforderlich ist. Zu diesem Zweck wird der Piezostapel mit einer Feldstärke VCor kontinuierlich bis zum Zeitpunkt t2 betrieben. Durch das Beaufschlagen des Piezostapels mit der Feldstärke VCor kann die Depolarisation rückgängig gemacht werden, so dass sich die Länge des Piezostapels wieder vergrößert. Zum Zeitpunkt t2 hat die tatsächliche Länge (Istlänge IL) wiederum den Sollwert SL erreicht. Aus diesem Grund kann der Piezostapel nun wieder mit der Feldstärke VOp betrieben werden, wodurch sich die Länge des Piezostapels 1 wiederum vergrößert. Zum Zeitpunkt t3 erreicht die Längenänderung wiederum den vorgegebenen Schwellwert, wodurch der Piezostapel 1 wiederum mit der dritten Feldstärke VCor bis zum Zeitpunkt t4 betrieben wird, usw.

Wie aus Fig. 2 ohne Weiteres ersichtlich ist, ist die für die aktive Nullpunktskorrektur verwendete dritte Feldstärke VCor größer als die im Betrieb verwendete zweite Feldstärke VOp und die für den Polungsprozess verwendete erste Feldstärke VPol.

Die Solllänge, d.h. die Ausgangslage der Länge des Piezostapels 1, und die zulässige Längenänderung können über bekannte Leerhub-Detektionsverfahren erfasst werden.

Der Vorteil des beschriebenen Verfahrens besteht darin, dass die erfindungsgemäß durchgeführte aktive Nullpunktskorrektur keinen hydraulischen Spielausgleich notwendig macht. Ebenso kann auf teure, aufwändige Schaltungen verzichtet werden, die einen verpolten Betrieb des Piezostapels erlauben. Im Gegensatz zu reinen Adaptionsverfahren wird beim erfindungsgemäßen Vorgehen eine tatsächliche, physikalische Korrektur der Nullpunktslage vorgenommen. Hierdurch bedingt muss das Injektordesign keine Rücksicht auf Verschiebungen der Nullpunktslage nehmen. Insbesondere kann eine Depolarisation eines Piezostapels im Laufe der Zeit auch im Regelbetrieb des Kraftstoffinjektrors rückgängig gemacht werden.

## Patentansprüche

1. Verfahren zum Ansteuern eines einen Piezostapel (1) aufweisenden piezoelektrischen Aktors für einen Krafstoffinjektor, wobei es sich bei dem Piezostapel (1) um einen im Rahmen seiner Herstellung durch einen Polungsprozess initial mit einer ersten Feldstärke (VPol) gepolten Piezostapel (1) handelt, woraus eine erste Länge (L1) des Piezostapels (1) resultiert, bei dem
- der Piezostapel (1) im Regelbetrieb mit einer zweiten Feldstärke (VOp) angesteuert wird, die kleiner als die erste Feldstärke (VPol) ist, wobei in Abhängigkeit von der zweiten Feldstärke (VOp) eine Solllänge (SL) des Piezostapels (1) definiert ist;
- eine durch Depolarisation verursachte Veränderung der Länge des Piezostapels (1) in Abhängigkeit von der zweiten Feldstärke (VOp) im Vergleich zu der Solllänge (SL) des Piezostapels (1) überwacht wird;
- bei Erreichen eines vorgegebenen Schwellwerts (SW) einer solchen Veränderung der Länge des Piezostapels (1) in Abhängigkeit von der zweiten Feldstärke (VOp) bis zum Erreichen seiner Solllänge (SL) mit einer dritten Feldstärke (VCor) betrieben wird.

2. Verfahren nach Anspruch 1, **dadurch gekennzeichnet, dass** die dritte Feldstärke (VCor) größer ist als die zweite Feldstärke (VOp).

3. Verfahren nach Anspruch 1 oder 2, **dadurch gekennzeichnet, dass** die dritte Feldstärke (VCor) größer ist als die erste Feldstärke (VPol).

4. Verfahren nach einem der vorhergehenden Ansprüche, **dadurch gekennzeichnet, dass** der Piezostapel nach Erreichen des vorgegebenen Schwellwerts kontinuierlich mit der dritten Feldstärke (VCor) betrieben wird bis die tatsächliche Länge des Piezostapels (1) der Solllänge (SL) entspricht.

5. Verfahren nach einem der vorhergehenden Ansprüche, **dadurch gekennzeichnet, dass** der Piezostapel (1) nach erneutem Erreichen seiner Solllänge (SL) mit der zweiten Feldstärke (VOp) betrieben wird.

6. Verfahren nach einem der vorhergehenden Ansprüche, **dadurch gekennzeichnet, dass** die Solllänge (L2), welche eine Ausgangslage des Piezostapels ohne Ansteuerung vorgibt, durch ein Leerhub-Detektionsverfahren ermittelt wird.

7. Verfahren nach einem der vorhergehenden Ansprüche, **dadurch gekennzeichnet, dass** die Längenänderung durch ein Leerhub-Detektionsverfahren ermittelt wird.

8. Anordnung zur Ansteuerung eines piezoelektrischen Aktors umfassend einen piezoelektrischen Aktor für einen Kraftstoffinjektor mit einem Piezostapel (1), wobei es sich bei dem Piezostapel um einen im Rahmen seiner Herstellung durch einen Polungsprozess initial mit einer ersten Feldstärke (VPol) gepolten Piezostapel (1) handelt, woraus eine erste Länge (L1) des Piezostapels (1) resultiert, wobei die Ansteuerung dazu ausgebildet ist,
- den Piezostapel (1) im Regelbetrieb mit einer zweiten Feldstärke (VOp) anzusteuern, die kleiner als die erste Feldstärke (VPol) ist, wobei in Abhängigkeit der zweiten Feldstärke (VOp) eine Solllänge (SL) des Piezostapels (1) definiert ist;
- eine durch Depolarisation verursachte Veränderung der Länge des Piezostapels (1) in Abhängigkeit von der zweiten Feldstärke (VOp) im Vergleich zu der Solllänge (SL) des Piezostapels (1) zu überwachen;
- bei Erreichen eines vorgegebenen Schwellwerts (SW) einer solchen Änderung der Länge des Piezostapels (1) bis zum Erreichen seiner Solllänge (SL) mit einer dritten Feldstärke (VCor) zu betreiben.

9. Anordnung nach Anspruch 8, **dadurch gekennzeichnet, dass** diese ferner dazu ausgebildet ist, den Piezostapel kontinuierlich mit der dritten Feldstärke (VCor) zu betreiben bis die tatsächliche Länge des Piezostapels (1) der Solllänge (SL) entspricht.

10. Anordnung nach Anspruch 8 oder 9, **dadurch gekennzeichnet, dass** diese ferner dazu ausgebildet ist, den Piezostapel (1) nach erneutem Erreichen seiner Solllänge (SL) mit der zweiten Feldstärke zu betreiben.

11. Anordnung nach einem der Ansprüche 8 bis 10, **dadurch gekennzeichnet, dass** diese ferner dazu ausgebildet ist, die Solllänge (SL), welche eine Ausgangslage des Piezostapels vorgibt, und/oder die Längenänderung durch ein Leerhub-Detektionsverfahren ermittelt wird.

## Claims

1. Method for driving a piezoelectric actuator, which has a piezo stack (1), for a fuel injector, wherein the piezo stack (1) is a piezo stack (1) which, during its production, is polarized by a polarization process initially at a first field strength (VPol), this resulting in a first length (L1) of the piezo stack (1), in which method
- the piezo stack (1) is driven during regular operation at a second field strength (VOp) which is smaller than the first field strength (VPol), wherein a setpoint length (SL) of the piezo stack (1) is defined as a function of the second field strength (VOp);
- a change in length of the piezo stack (1), which change is caused by depolarization, as a function of the second field strength (VOp) is monitored in comparison to the setpoint length (SL) of the piezo stack (1);
- when a prespecified threshold value (SW) for a change in length of the piezo stack (1) of this kind as a function of the second field strength (VOp) is reached, said piezo stack is operated at a third field strength (VCor) until its setpoint length (SL) is reached.

2. Method according to Claim 1, **characterized in that** the third field strength (VCor) is greater than the second field strength (VOp).

3. Method according to Claim 1 or 2, **characterized in that** the third field strength (VCor) is greater than the first field strength (VPol).

4. Method according to one of the preceding claims, **characterized in that** the piezo stack, after the prespecified threshold value is reached, is continuously operated at the third field strength (VCor) until the actual length of the piezo stack (1) corresponds to the setpoint length (SL).

5. Method according to one of the preceding claims, **characterized in that** the piezo stack (1) is operated at the second field strength (VOp) after its setpoint length (SL) is reached again.

6. Method according to one of the preceding claims, **characterized in that** the setpoint length (L2), which prespecifies a starting position of the piezo stack without driving, is determined by an idle stroke detection method.

7. Method according to one of the preceding claims, **characterized in that** the change in length is determined by an idle stroke detection method.

8. Arrangement for driving a piezoelectric actuator comprising a piezoelectric actuator for a fuel injector comprising a piezo stack (1), wherein the piezo stack is a piezo stack (1) which, during its production, is polarized by a polarization process initially at a first field strength (VPol), this resulting in a first length (L1) of the piezo stack (1), wherein the driving is designed
- to drive the piezo stack (1) during regular operation at a second field strength (VOp) which is smaller than the first field strength (VPol), wherein a setpoint length (SL) of the piezo stack (1) is defined as a function of the second field strength (VOp);
- to monitor a change in length of the piezo stack (1), which change is caused by depolarization, as a function of the second field strength (VOp) in comparison to the setpoint length (SL) of the piezo stack (1);
- when a prespecified threshold value (SW) for a change in length of the piezo stack (1) of this kind is reached, to operate said piezo stack at a third field strength (VCor) until its setpoint length (SL) is reached.

9. Arrangement according to Claim 8, **characterized in that** it is further designed to continuously operate the piezo stack at the third field strength (VCor) until the actual length of the piezo stack (1) corresponds to the setpoint length (SL).

10. Arrangement according to Claim 8 or 9, **characterized in that** it is further designed to operate the piezo stack (1) at the second field strength after its setpoint length (SL) is reached again.

11. Arrangement according to one of Claims 8 to 10, **characterized in that** it is further designed to determine the setpoint length (SL), which prespecifies a starting position of the piezo stack, and/or the change in length by an idle stroke detection method.

## Revendications

1. Procédé de commande d'un actionneur piézo-électrique prévu pour un injecteur de carburant et présentant un empilement piézo (1),
l'empilement piézo (1) étant un empilement piézo (1) polarisé initialement à une première intensité de champ (VPol) lors d'une opération de polarisation intégrée dans sa fabrication, de telle sorte que l'empilement piézo (1) prend une première longueur (L1),
- l'empilement piézo (1) étant commandé en fonctionnement de réglage par une deuxième intensité de champ (VOp) inférieure à la première intensité de champ (VPol), une longueur de consigne (SL) de l'empilement piézo (1) étant définie en fonction de la deuxième intensité de champ (VOp),
- une modification, résultant de la dépolarisation en fonction de la deuxième intensité de champ (VOp), de la longueur de l'empilement piézo (1) par rapport à la longueur de consigne (SL) de l'empilement piézo (1) étant surveillée et
- lorsqu'une valeur de seuil (SW), prédéterminée en fonction de la deuxième intensité de champ (VOp), de la modification de la longueur de l'empilement piézo (1) est atteinte, le fonctionnement se poursuit à une troisième intensité de champ (VCor) jusqu'à ce que la longueur de consigne (SL) soit atteinte.

2. Procédé selon la revendication 1, **caractérisé en ce que** la troisième intensité de champ (VCor) est supérieure à la deuxième intensité de champ (VOp).

3. Procédé selon les revendications 1 ou 2, **caractérisé en ce que** la troisième intensité de champ (VCor) est supérieure à la première intensité de champ (VPol).

4. Procédé selon l'une des revendications précédentes, **caractérisé en ce qu'**après que la valeur de seuil prédéterminée a été atteinte, l'empilement piézo est activé en continu à la troisième intensité de champ (VCor) jusqu'à ce que la longueur effective de l'empilement piézo (1) corresponde à la longueur de consigne (SL).

5. Procédé selon l'une des revendications précédentes, **caractérisé en ce qu'**après avoir atteint de nouveau sa longueur de consigne (SL), l'empilement piézo (1) est activé à la deuxième intensité de champ (VOp).

6. Procédé selon l'une des revendications précédentes, **caractérisé en ce que** la longueur de consigne (L2) qui définit la longueur initiale de l'empilement piézo non activé est déterminée par une opération de détection de course à vide.

7. Procédé selon l'une des revendications précédentes, **caractérisé en ce que** la modification de longueur est déterminée par une opération de détection de course à vide.

8. Ensemble de commande d'un actionneur piézo-électrique comprenant un actionneur piézo-électrique pour injecteur de carburant doté d'un empilement piézo (1),
l'empilement piézo (1) étant un empilement piézo (1) polarisé initialement à une première intensité de champ (VPol) lors d'une opération de polarisation intégrée dans sa fabrication, de telle sorte que l'empilement piézo (1) prend une première longueur (L1), la commande étant configurée pour
- commander l'empilement piézo (1) en fonctionnement de réglage par une deuxième intensité de champ (VOp) inférieure à la première intensité de champ (VPol), une longueur de consigne (SL) de l'empilement piézo (1) étant définie en fonction de la deuxième intensité de champ (VOp),
- surveiller une modification, résultant de la dépolarisation en fonction de la deuxième intensité de champ (VOp), de la longueur de l'empilement piézo (1) par rapport à la longueur de consigne (SL) de l'empilement piézo (1) et
- poursuivre le fonctionnement à une troisième intensité de champ (VCor) jusqu'à ce que la longueur de consigne (SL) soit atteinte lorsqu'une valeur de seuil (SW), prédéterminée en fonction de la deuxième intensité de champ (VOp), de la modification de la longueur de l'empilement piézo (1) est atteinte.

9. Ensemble selon la revendication 8, **caractérisé en ce qu'**il est en outre configuré pour activer en continu l'empilement piézo à la troisième intensité de champ (VCor) jusqu'à ce que la longueur effective de l'empilement piézo (1) corresponde à la longueur de consigne (SL).

10. Ensemble selon les revendications 8 ou 9, **caractérisé en ce qu'**il est en outre configuré pour activer l'empilement piézo (1) à la deuxième intensité de champ après que l'empilement piézo (1) a atteint de nouveau la longueur de consigne (SL).

11. Ensemble selon les revendications 8 à 10, **caractérisé en ce qu'**il est en outre configuré pour déterminer par une opération de détection de course à vide la longueur de consigne (SL) qui définit la longueur initiale de l'empilement piézo et/ou la modification de longueur.
